# EUROPÄISCHE PATENTSCHRIFT

(11) **EP 4 356 698 B1**
(45) Veröffentlichungstag und Bekanntmachung des Hinweises auf die Patenterteilung: **23.09.2026**
(21) Anmeldenummer: 22735297.8
(22) Anmeldetag: 10.06.2022
(51) Int. Cl.: H05K 7/14, H05K 7/20

(54) **ELEKTRISCHE SCHALTUNGSANORDNUNG UND ELEKTRISCHE ANTRIEBSANORDNUNG**
ELECTRICAL CIRCUIT ARRANGEMENT AND ELECTRICAL DRIVE ARRANGEMENT
AGENCEMENT DE CIRCUIT ÉLECTRIQUE ET AGENCEMENT D'ENTRAÎNEMENT ÉLECTRIQUE

(30) Priorität: 14.06.2021 DE 102021115272
(43) Veröffentlichungstag der Anmeldung: 24.04.2024
(73) Patentinhaber: Schaeffler Technologies AG & Co. KG, 91074 Herzogenaurach (DE)
(72) Erfinder: GRAMANN, Nicolai, 77871 Renchen (DE); CRETU, Mihai, 77815 Bühl (DE); RITTGEROTT, Thorsten, 77652 Offenburg (DE); KÖRNER, Julian, 76137 Karlsruhe (DE); ENDERLE, Eduard, 77723 Gengenbach (DE); JACKSTÄDT, Sebastian, 40723 Hilden (DE)
(74) Vertreter: Schaeffler Technologies
(86) Internationale Anmeldenummer: PCT/DE2022/100437
(87) Internationale Veröffentlichungsnummer: WO 2022/262903

(56) Entgegenhaltungen:
- EP-A1- 3 579 396
- EP-A2- 2 023 473
- US-A1- 2017 158 042
- US-B1- 9 241 428

## Beschreibung

Die Erfindung betrifft eine elektrische Schaltungsanordnung umfassend einen ersten Inverter und einen zweiten Inverter. Weiterhin betrifft die Erfindung eine elektrische Antriebsanordnung.

In Kraftfahrzeugen mit elektrischem Antrieb werden beispielsweise in den elektrischen Antriebsträngen Leistungselektronikschaltungen verwendet, welche eine oder mehrere Inverter umfassen. Mit dem Inverter kann in einem Fahrbetrieb des Kraftfahrzeugs ein Gleichstrom, welcher z.B. einem als Traktionsbatterie ausgebildeten Energiespeicher entnommen wird, in einen Wechselstrom zum Betrieb einer elektrischen Maschine gewandelt werden. Umgekehrt kann ein derartiger Inverter auch zum Gleichrichten eines von der elektrischen Maschine in einem Generatorbetrieb erzeugten Wechselstroms eingesetzt werden, damit beispielsweise in einem Rekuperationsbetrieb die Traktionsbatterie des Kraftfahrzeugs geladen werden kann.

Zwei Inverter können beispielsweise zum Antrieb von zwei elektrischen Maschinen verwendet werden, welche jeweils ein Rad einer gemeinsamen Achse des Kraftfahrzeugs antreiben. Dies bedeutet, dass die beiden Inverter, welche jeweils einer der elektrischen Maschinen zugeordnet sind, als Teil der Achse bzw. eines Kraftfahrzeugs vorgesehen und im Kraftfahrzeug angeordnet werden müssen. Um einen korrekten Betrieb der Inverter zu ermöglichen, ist es in der Regel erforderlich, dass jeder Inverter ein Kühlsystem aufweist sowie weitere, zum Betrieb des Inverters notwendige Komponenten wie Filterschaltungen, Steuerplatinen oder ähnliches umfasst. Dies wirkt sich jedoch nachteilig auf den Bauraumbedarf im Inneren eines Kraftfahrzeugs aus, da bei zwei Invertern die weiteren Komponenten in der Regel dann ebenfalls jeweils doppelt vorhanden sind.

Aus jeder der EP 2 023 473 A2, der US 2017/158042 A1 und der EP 3 579 396 A1 ist eine elektrische Schaltungsanordnung gemäß dem Oberbegriff des Anspruchs 1 bekannt.

Der Erfindung liegt daher die Aufgabe zugrunde, eine verbesserte elektrische Schaltungsanordnung mit zwei Invertern anzugeben, welche insbesondere eine kompaktere Ausführung und somit eine platzsparende Anordnung der elektrischen Schaltung ermöglicht.

Zur Lösung dieser Aufgabe ist erfindungsgemäß vorgesehen, dass die elektrische Schaltungsanordnung ein Gehäuse mit einem sich im Inneren des Gehäuses erstreckenden Plattenabschnitt umfasst, wobei der Plattenabschnitt das Innere des Gehäuses in eine erste Kammer und eine zweite Kammer teilt, wobei eine erste Seite des Plattenabschnitts die erste Kammer zumindest teilweise begrenzt und eine der ersten Seite gegenüberliegende zweite Seite des Plattenabschnitts die zweite Kammer zumindest teilweise begrenzt, wobei der erste Inverter und der zweiter Inverter jeweils wenigstens ein Leistungsmodul umfassen und das Leistungsmodul des ersten Inverters an der ersten Seite des Plattenabschnitts angeordnet ist und das Leistungsmodul des zweiten Inverters an der zweiten Seite des Plattenabschnitts angeordnet ist.

Das an der ersten Seite angeordnete, wenigstens eine Leistungsmodul des ersten Inverters ist somit in der ersten Kammer angeordnet. Entsprechend ist das an der zweiten Seite des Plattenabschnitts angeordnete, wenigstens eine Leistungsmodul des zweiten Inverters in der zweiten Kammer angeordnet. Jeder der Inverter kann ein Leistungsmodul oder mehrere Leistungsmodule umfassen, wobei die Leistungsmodule des ersten Inverters bevorzugt an der ersten Seite des Plattenabschnitts und die Leistungsmodule des zweiten Inverters an der zweiten Seite des Plattenabschnitts angeordnet sind. Mehrere Leistungsmodule können beispielsweise vorhanden sein, wenn die Inverter jeweils zur Erzeugung und/oder Wandlung eines mehrphasigen Wechselstroms ausgebildet sind, wobei pro Phase des Wechselstroms beispielsweise ein eine Halbbrücke aus zwei Transistoren umfassendes Leistungsmodul vorhanden sein kann.

Durch die Anordnung der Leistungsmodule an den gegenüberliegenden Seiten des Plattenabschnitts wird eine kompakte Anordnung der Inverter im Inneren des Gehäuses der elektrischen Schaltungsanordnung ermöglicht. Der Plattenabschnitt kann sich insbesondere mittig durch das Gehäuse erstrecken und das Innere in zwei gleich große oder zumindest im Wesentlichen gleich große Kammern teilen. Der Plattenabschnitt kann als ein Bestandteil des Gehäuses ausgeführt sein, welcher zum Beispiel einstückig mit weiteren Abschnitten des Gehäuses ausgebildet oder an diesen befestigt ist.

Die Verwendung des Plattenabschnitts als Trägerabschnitt für die Schaltungselemente der Inverter ermöglicht eine kleinbauende Ausführung des Gehäuses. Weiterhin ist es möglich, dass das Gehäuse, insbesondere der Plattenabschnitt, aus einem zumindest teilweise bzw. bereichsweise elektrisch leitfähigen Material bestehen, sodass auch eine Abschirmung zwischen der ersten Kammer und der zweiten Kammer und somit zwischen dem ersten Inverter und dem zweiten Inverter erzeugt werden kann. Auf diese Weise können Störungen, welche auf die Schaltvorgänge der Transistoren in den Leistungsmodulen zurückgehen, von dem jeweils anderen Inverter abgeschirmt werden.

Die kompakte Anordnung der Inverter in einem Gehäuse ist insbesondere bei Einsatz der elektrischen Schaltungsanordnung in einem Kraftfahrzeug von Vorteil, da der insgesamt im Inneren eines Kraftfahrzeugs zur Verfügung stehende Bauraum stark limitiert ist. Vorteilhaft wird auf diese Weise die Verwendung der elektrischen Schaltungsanordnung als Teil einer elektrischen Achse eines Kraftfahrzeugs vereinfacht. Dabei können die beiden Inverter insbesondere zum Betrieb von zwei elektrischen Maschinen eingesetzt werden, welche jeweils einem Rad des Kraftfahrzeugs zugeordnet sind.

Die Anordnung des ersten Inverters und des zweiten Inverters in einem gemeinsamen Gehäuse und insbesondere die Anordnung der Leistungsmodule an den gegenüberliegenden Seiten des Plattenabschnitts ermöglichen es vorteilhaft, dass die Anzahl von weiteren Komponenten der elektrischen Schaltungsanordnung reduziert werden kann, da durch die räumlich benachbarte Anordnung der Inverter ein gemeinsames Benutzen der Komponenten möglich ist, wie nachfolgend genauer beschrieben wird.

Ferner vereinfacht sich die Kühlung der Inverter und insbesondere ihrer Leistungsmodule, da nur das gemeinsam genutzte Gehäuse an einen Kühlkreislauf, beispielsweise den Kühlkreislauf eines Kraftfahrzeugs, angebunden werden muss, um die im Betrieb der Inverter in den Leistungsmodulen entstehende Wärme abzuführen.

Vorteilhaft wird es auch ermöglicht, dass für beide Inverter ein gemeinsamer Gleichstromsensor verwendet wird. Der Gleichstromsensor kann einen den Invertern zugeführten oder von diesen erzeugten Gleichstrom messen. Der Gleichstromsensor kann im Inneren des Gehäuses, zum Beispiel in der ersten Kammer oder in der zweiten Kammer, angeordnet sein.

Erfindungsgemäß kann vorgesehen sein, dass der Plattenabschnitt wenigstens einen sich im Inneren des Plattenabschnitts erstreckenden Kühlkanal aufweist. Der Plattenabschnitt kann einen oder mehrere, sich im Inneren des Plattenabschnitts erstreckende Kühlkanäle aufweisen. Der Plattenabschnitt kann somit eine Kühlplatte sein, welche zur Kühlung der an den Seiten des Plattenabschnitts angeordneten Komponenten, insbesondere der Leistungsmodule der Inverter, verwendet werden kann. Der Kühlkanal oder die mehreren, insbesondere miteinander verbundenen Abschnitte eines Kühlkanals im Inneren des Plattenabschnitts können über eine oder mehrere gehäuseseitige Anschlüsse mit einem Kühlkreislauf, beispielsweise einen Wasserkühlkreislauf, eines Kraftfahrzeugs verbunden werden. An dem Gehäuse der elektrischen Schaltungsanordnung können somit wenigstens ein Einlass und wenigstens ein Auslass vorgesehen sein, welche mit dem wenigstens einen Kühlkanal im Inneren des Plattenabschnitts kommunizieren und die Zufuhr eines Kühlmediums wie Kühlwasser oder Kühlluft ermöglichen.

In einer bevorzugten Ausgestaltung der Erfindung kann vorgesehen sein, dass die Leistungsmodule jeweils einen Kühlkörper aufweisen, wobei die Leistungsmodule jeweils mit dem Kühlkörper an dem Plattenabschnitt angeordnet sind, wobei dem Kühlkörper über den Kühlkanal des Plattenabschnitts ein Kühlmedium zuführbar ist. Der Kühlkörper der Leistungsmodule kann beispielsweise eine Mäander- oder Finnenstruktur aufweisen, welche mit der jeweiligen Seite des Plattenabschnitts einen weiteren Kühlkanal begrenzen. In dem Plattenabschnitt kann beispielsweise wenigstens eine Öffnung vorgesehen sein, welche zu dem im Inneren des Plattenabschnitts verlaufenden Kühlkanal führt. An oder in dieser Öffnung kann der Kühlkörper eines Leistungsmoduls angeordnet werden, sodass dem Kühlkörper bzw. einem von dem Kühlkörper und dem Plattenabschnitt begrenzten, weiteren Kühlkanal das Kühlmedium zugeführt werden kann. Je nach Ausgestaltung des Kühlkörpers ist es möglich, dass dieser mit dem Plattenabschnitt einen oder mehrere weitere Kühlkanäle, welche von dem Kühlmedium durchströmt werden, begrenzt. Um ein Austreten des Kühlmittels zu verhindern, kann insbesondere vorgesehen sein, dass zwischen dem Leistungsmodul und der jeweiligen Seite des Plattenabschnitts eine oder mehrere Axialdichtungen angeordnet sind.

Erfindungsgemäß kann vorgesehen sein, dass die Gleichstromseiten des ersten Inverters und des zweiten Inverters mit einem in der ersten Kammer und insbesondere an der ersten Seite des Plattenabschnitts angeordneten Kondensator verbunden sind. Ein in der ersten Kammer angeordneter Kondensator kann beispielsweise als ein X-Kondensator eingesetzt werden und parallel zu den Anschlüssen an der Gleichstromseite, zum Beispiel einem DC⁺ und einem DC⁻ Anschluss, des ersten Inverters geschaltet sein. Durch eine Verbindung der Gleichstromseite des zweiten Inverters mit der Gleichstromseite des ersten Inverters bzw. mit dem Kondensator wird es ermöglicht, dass auch die in der zweiten Kammer angeordnete zweite Inverterschaltung den in der ersten Kammer angeordneten Kondensator verwenden kann. Es ist möglich, dass der Kondensator eine erhöhte Kapazität verglichen mit einem nur für einen Inverter verwendeten Kondensator aufweist. Vorteilhaft kann jedoch auf einen zweiten Kondensator verzichtet werden, da der erste Inverter und der zweite Inverter mit demselben Kondensator verbunden werden können. Dadurch kann die Baugröße der elektrischen Schaltungsanordnung vorteilhaft reduziert werden.

Die Unterscheidung zwischen erster Kammer und zweiter Kammer dient vorliegend zum Beschreiben der Anordnung der Komponenten der elektrischen Schaltungsanordnung in den verschiedenen Kammern, welche im Inneren des Gehäuses durch den Plattenabschnitt ausgebildet werden. Es ist dabei möglich, dass die in der ersten Kammer angeordneten Komponenten auch in der zweiten Kammer angeordnet werden und umgekehrt. Auch eine Aufteilung einer der Komponenten in mehrere Teilkomponenten, beispielweise eines Kondensators in zwei Teilkondensatoren, ist möglich. Dabei kann eine Teilkomponente bzw. ein Teilkondensator in der ersten Kammer und eine weitere Teilkomponente bzw. ein weiterer Teilkondensator in der zweiten Kammer angeordnet werden.

Zur Verbindung eines in der ersten Kammer angeordneten Kondensators mit einer Gleichstromseite des Leistungsmoduls des zweiten Inverters kann erfindungsgemäß vorgesehen sein, dass der Kondensator mit der Gleichstromseite des Leistungsmoduls des zweiten Inverters über wenigstens eine Stromschiene verbunden ist, wobei sich die Stromschiene durch eine Aussparung in dem Plattenabschnitt erstreckt. Eine Stromschiene kann dabei z. B. wenigstens einen gleichstromseitigen Anschluss bzw. wenigstens einen DC-Kontakt des Leistungsmoduls des ersten Inverters mit einem gleichstromseitigen Anschluss des Leistungsmoduls des zweiten Inverters verbinden, wobei der Kondensator zum Beispiel an den gleichstromseitigen Anschlüssen des Leistungsmoduls bzw. der Leistungsmodule des ersten Inverters angebunden ist. Auf diese Weise kann erreicht werden, dass der Kondensator auch parallel zu der Gleichstromseite des zweiten Inverters geschaltet ist.

In einer bevorzugten Ausgestaltung der Erfindung kann vorgesehen sein, dass die Stromschiene als eine mehrere leitfähige Bleche umfassende laminierte Stromschiene ausgeführt ist. Die einzelnen leitfähigen Bleiche der Stromschiene sind insbesondere gegeneinander isoliert, wobei die Bleche der Stromschiene alternierend ein positives und ein negatives Potential führen bzw. alternierend die DC⁺ und DC⁻-Anschlüsse der Inverter miteinander verbinden. Dazu können die laminierten, leitfähigen Bleche jeweils zu unterschiedlichen Seiten abstehende Kontaktfahnen haben, über welche jeweils die Mehrzahl der den unterschiedlichen Polen zugeordneten leitfähigen Bleche der Stromschiene kontaktiert werden können. Auf diese Weise kann eine niederinduktive, kompakte und nur ein vergleichsweise geringes Störfeld erzeugende Ausbildung der Stromschiene erreicht werden.

Erfindungsgemäß ist vorgesehen, dass die Gleichstromseiten des ersten Inverters und des zweiten Inverters mit einer in der zweiten Kammer angeordneten Filterschaltung verbunden sind. Die Filterschaltung kann dabei beispielsweise mit der Gleichstromseite des zweiten Inverters und/oder einem an dem zweiten Inverter angeschlossenen Kondensator verbunden sein. Die Filterschaltung kann ein oder mehrere Filterelemente umfassen, welche insbesondere die Wechselstromanteile bei den Schaltfrequenzen der Inverter und/oder ihre Oberschwingungen filtern. Dies ermöglicht eine kompakte Ausbildung der elektrischen Schaltungsanordnung, insbesondere bei Verwendung eines in der ersten Kammer angeordneten Kondensators.

Die Filterschaltung kann dabei mehrere Filterkomponenten umfassen. Es ist auch möglich, dass die Filterschaltung in der ersten Kammer angeordnet ist oder dass die Filterschaltung mehrere Filterkomponenten aufweist, wobei wenigstens eine Filterkomponente in der ersten Kammer und wenigstens eine Filterkomponente in der zweiten Kammer angeordnet ist.

Erfindungsgemäß kann vorgesehen sein, dass zwischen der Filterschaltung und dem Leistungsmodul des zweiten Inverters ein Abschirmelement angeordnet ist. Das Abschirmelement kann insbesondere die zweite Kammer in zwei Teilkammern teilen, sodass die Filterschaltung von dem Leistungsmodul des zweiten Inverters abgeschirmt ist. Auf diese Weise kann die Filterwirkung der Filterschaltung verbessert werden. Es ist möglich, dass weitere Abschirmelemente in der zweiten Kammer und/oder in der ersten Kammer angeordnet sind, welche die entsprechende Kammer in unterschiedliche Bereiche bzw. eine oder mehrere Teilkammern aufteilen können. Beispielsweise ist es möglich, dass auch zwischen einem in der ersten Kammer angeordneten Kondensator und dem ersten Inverter ein Abschirmelement angeordnet ist. Das Abschirmelement kann beispielsweise als ein elektrisch leitfähiges Blech, welches insbesondere mit weiteren, elektrisch leitfähigen Abschnitten des Gehäuses verbunden ist, ausgeführt werden.

In einer bevorzugten Ausgestaltung der Erfindung kann vorgesehen sein, dass in der ersten Kammer wenigstens eine erste Steuereinrichtung und in der zweiten Kammer wenigstens eine zweite Steuereinrichtung angeordnet ist, wobei die erste Steuereinrichtung zur Steuerung des ersten Inverters und/oder einer mit dem ersten Inverter verbundenen Komponente ausgebildet ist und die zweite Steuereinrichtung zur Steuerung des zweiten Inverters und/oder einer mit dem zweiten Inverter verbundenen Komponente ausgebildet ist. Unter einer Steuerung wird im Rahmen dieser Beschreibung auch eine Regelung verstanden.

Eine erste Steuereinrichtung kann beispielsweise als Treiberschaltung für den ersten Inverter eingerichtet bzw. ausgebildet sein. Zusätzlich oder alternativ dazu kann eine erste Steuereinrichtung auch als Komponentensteuerung eingerichtet oder ausgebildet sein, welche eine mit dem ersten Inverter direkt oder mittelbar über eine durch den Inverter betriebene elektrische Maschine verbundene Komponente steuert. Beispielsweise kann eine über den ersten Inverter betriebene elektrische Maschine mit einer als Getriebe ausgebildeten Komponente gekoppelt sein, wobei das Getriebe mit einer in der ersten Kammer angeordneten, als Getriebesteuerung bzw. als Hydrauliksteuerung für ein Getriebe ausgebildeten ersten Steuereinrichtung verbunden ist. Analog gilt dies auch für die wenigstens eine zweite Steuereinrichtung, welche in der zweiten Kammer angeordnet ist und zur Steuerung des zweiten Inverters und/oder einer mit dem zweiten Inverter direkt oder mittelbar über eine von dem zweiten Inverter betriebene elektrische Maschine verbundene Komponente eingerichtet bzw. ausgebildet ist.

Alternativ ist es möglich, dass wenigstens eine gemeinsame Steuereinrichtung vorgesehen ist, welche zum Beispiel als Treiberschaltung für die Inverter und/oder als Steuereinrichtung für mehrere mit den elektrischen Maschinen verbundene Komponenten ausgebildet bzw. eingerichtet ist. Eine gemeinsame Steuereinrichtung kann dabei in der ersten Kammer oder in der zweiten Kammer angeordnet sein. Es ist auch möglich, dass eine gemeinsame Steuereinrichtung wenigstens zwei Teilsteuereinrichtungen umfasst, wobei wenigstens eine Teilsteuereinrichtung in der ersten Kammer und wenigstens eine weitere Teilsteuereinrichtung in der zweiten Kammer angeordnet ist.

Für eine erfindungsgemäße elektrische Antriebsanordnung ist vorgesehen, dass sie eine erfindungsgemäße elektrische Schaltungsanordnung sowie eine erste elektrische Maschine und eine zweite elektrische Maschine umfasst, wobei die erste elektrische Maschine und die zweite elektrische Maschine an dem Gehäuse der elektrischen Schaltungsanordnung tragend befestigt sind. Die erste elektrische Maschine ist dabei insbesondere mit dem ersten Inverter verbunden und die zweite elektrische Maschine ist insbesondere mit dem zweiten Inverter verbunden. Die elektrischen Maschinen können jeweils eine Getriebeeinheit, z. B. ein zweigängiges Planetengetriebe, umfassen oder mit einem solchen verbunden sein, wobei das Gehäuse der elektrischen Schaltungsanordnung dabei insbesondere auch die mit den elektrischen Maschinen verbundenen Getriebe trägt.

Tragend befestigt bedeutet in diesem Zusammenhang, dass eine ortsfeste Anordnung der gesamten elektrischen Antriebsanordnung durch Befestigung des Gehäuses der elektrischen Schaltungsanordnung, beispielsweise an einem Kraftfahrzeugchassis, möglich ist. Die ortsfeste Anordnung der ersten elektrischen Maschine und der zweiten elektrischen Maschine sowie der gegebenenfalls mit diesen verbundenen, weiteren Komponenten erfolgt vollständig oder zumindest zu einem großen Teil über das Gehäuse der elektrischen Schaltungsanordnung.

Es ist möglich, dass die erste elektrische Maschine und die zweite elektrische Maschine an gegenüberliegenden Seiten des Gehäuses angeordnet werden. Insbesondere kann die Seite, an der die erste elektrische Maschine angeordnet ist, der ersten Seite des Platenabschnitts im Inneren des Gehäuses zugewandt sein. Entsprechend kann die Seite, an der die zweite elektrische Maschine angeordnet ist, der zweiten Seite des sich im Inneren des Gehäuses erstreckenden Plattenabschnitts zugewandt sein. Auf diese Weise sind auch die erste elektrische Maschine und die zweite elektrische Maschine angrenzend an die erste Kammer bzw. die zweite Kammer im Inneren des Gehäuses angeordnet, wodurch sich auch für die elektrische Antriebsanordnung, welche beispielsweise als eine elektrisch antreibbare Achse eines Kraftfahrzeugs ausgeführt ist, ein kompakter Aufbau ergibt.

Sämtliche vorangehend in Bezug zu der erfindungsgemäßen elektrischen Schaltungsanordnung beschriebenen Vorteile und Ausgestaltungen gelten entsprechend für die elektrische Antriebsanordnung und umgekehrt.

Die Erfindung wird nachfolgend anhand von Ausführungsbeispielen unter Bezugnahme auf die Zeichnungen erläutert. Die Zeichnungen sind schematische Darstellungen und zeigen:
- Figur 1: ein Ausführungsbeispiel einer erfindungsgemäßen elektrischen Antriebsanordnung für ein Kraftfahrzeug,
- Figur 2: eine Explosionsdarstellung eines Ausführungsbeispiels einer erfindungsgemäßen elektrischen Schaltungsanordnung,
- Figur 3: eine Detailansicht eines Plattenabschnitts eines Gehäuses der elektrischen Schaltungsanordnung,
- Figur 4: eine Schnittansicht durch die elektrische Schaltungsanordnung,
- Figur 5: eine teilweise geschnittene Ansicht der zweiten Kammer der elektrischen Schaltungsanordnung,
- Figur 6: eine teilweise geschnittene Ansicht der ersten Kammer einer elektrischen Schaltungsanordnung,
- Figur 7: eine perspektivische Seitenansicht des teilweise geschnittenen Gehäuses der elektrischen Schaltungsanordnung, sowie
- Figur 8: ein Schaltplan der elektrischen Schaltungsanordnung.

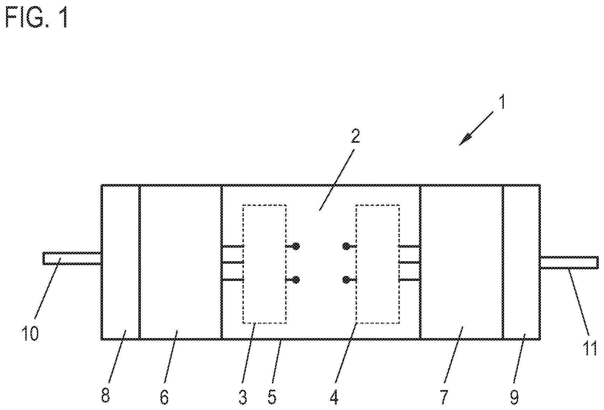

In Figur 1 ist ein Ausführungsbeispiel einer elektrischen Antriebsanordnung 1 dargestellt. Die elektrische Antriebsanordnung 1 umfasst eine elektrische Schaltungsanordnung 2, wobei die elektrische Schaltungsanordnung 2 einen ersten Inverter 3 und einen zweiten Inverter 4 sowie ein Gehäuse 5 umfasst. Die elektrische Antriebsanordnung 1 umfasst weiterhin eine erste elektrische Maschine 6, welche mit der Wechselstromseite des ersten Inverters 3 verbunden ist, sowie eine zweite elektrische Maschine 7, welche mit der Wechselstromseite des zweiten Inverters 4 verbunden ist.

Außerdem umfasst die elektrische Antriebsanordnung 1 eine erste Getriebeeinheit 8 sowie eine zweite Getriebeeinheit 9, wobei die erste Getriebeeinheit 8 mit der ersten elektrischen Maschine 6 und die zweite Getriebeeinheit 9 mit der zweiten elektrischen Maschine 7 gekoppelt ist. Die Getriebeeinheiten 8, 9 können jeweils beispielsweise als zweigängiges Planetengetriebe ausgeführt sein. Mit den Getriebeeinheiten 8, 9 ist jeweils eine Welle 10, 11 verbunden, welche beispielsweise bei einem Einsatz der elektrischen Antriebsanordnung 1 in einem Kraftfahrzeug jeweils mit einem unterschiedlichen Rad einer Achse des Kraftfahrzeugs verbunden werden können. Die elektrische Antriebsanordnung 1 stellt dabei eine elektrische Antriebsachse des Kraftfahrzeugs dar. Die elektrischen Maschinen 6, 7 sind an dem Gehäuse 5 der elektrischen Schaltungsanordnung 2 tragend befestigt, sodass die ganze elektrische Antriebsanordnung 1 mit Hilfe des Gehäuses 5 der Schaltungsanordnung 2 in einem Kraftfahrzeug angeordnet und befestigt werden kann.

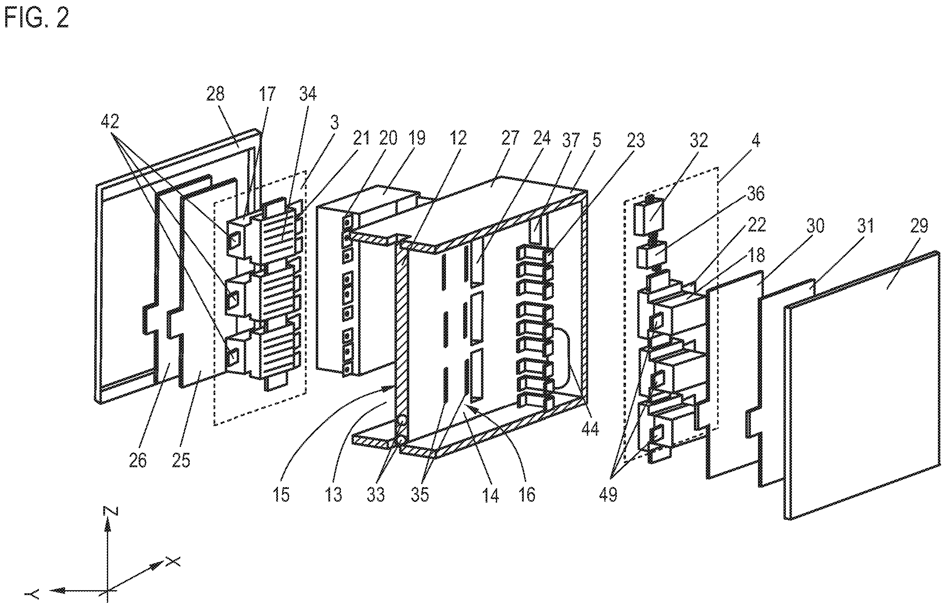

In Figur 2 ist eine Explosionsdarstellung eines Ausführungsbeispiels einer elektrischen Schaltungsanordnung 2 dargestellt. Das Gehäuse 5 umfasst einen sich im Inneren des Gehäuses 5 erstreckenden Plattenabschnitt 12, welcher das Innere des Gehäuses 5 in eine erste Kammer 13 und eine zweite Kammer 14 teilt. Der Plattenabschnitt 12 weist eine erste Seite 15 sowie eine zweite Seite 16 auf.

An der ersten Seite 15 des Plattenabschnitts 12 sind das oder die Leistungsmodule 17 des ersten Inverters 3 angeordnet. Der erste Inverter 3 umfasst in diesem Ausführungsbeispiel drei Leistungsmodule 17, welche jeweils eine aus zwei Transistoren gebildete Halbbrücke umfassen. Entsprechend umfasst der zweite Inverter 4 ebenfalls drei Leistungsmodule 18, welche entsprechend den Leistungsmodulen 17 des ersten Inverters 3 ausgebildet und an der zweiten Seite 16 des Plattenabschnitts 12 angeordnet sind. Der erste Inverter 3 und der zweite Inverter 4 sind jeweils als ein dreiphasiger Pulswechselrichter, beispielsweise als ein B6-Brückengleichrichter, ausgeführt.

In der ersten Kammer 13 ist weiterhin ein Kondensator 19 angeordnet, welcher mit den Gleichstromseiten der Inverter 3 und 4 verbunden ist. Dazu können die Anschlüsse 20 des Kondensators 19 direkt mit den gleichstromseitigen Anschlüssen 21 der Leistungsmodule 17 verbunden werden. Die gleichstromseitigen Anschlüsse 22 der zweiten Leistungsmodule 18 können mit dem Kondensator 19 und/oder den Anschlüssen 21 des ersten Inverters 3 jeweils über Stromschienen 23 verbunden werden. Die Stromschienen 23 erstrecken sich dabei durch eine oder mehrere Öffnungen 24 im Plattenabschnitt 12, sodass eine Verbindung zwischen dem in der ersten Kammer 13 angeordneten Kondensator 19 und der Gleichstromseite des zweiten Inverters 4 über den Plattenabschnitt 12 hinweg erfolgen kann.

In der ersten Kammer 13 sind weiterhin zwei erste Steuereinheiten 25, 26 angeordnet, wobei die erste Steuereinheit 25 als eine Treiberschaltung zum Betrieb des ersten Inverters 3 ausgebildet ist. Die weitere erste Steuerschaltung 26 ist als eine Getriebesteuerschaltung, beispielsweise als eine Hydrauliksteuerschaltung, zum Betrieb des mit der über den ersten Inverter 3 betriebenen, ersten elektrischen Maschine 6 verbundenen Getriebes 8 eingerichtet bzw. ausgebildet. Entsprechend sind in der zweiten Kammer 14 sind zwei zweite Steuerschaltungen 30, 31 angeordnet, wobei die zweite Steuerschaltung 30 als Treiberschaltung zum Betrieb des zweiten Inverters 4 ausgebildet ist. Die zweite Steuerschaltung 31 ist als eine Getriebesteuerschaltung, beispielsweise als eine Hydrauliksteuerschaltung, zur Steuerung des Getriebes 9 eingerichtet bzw. ausgebildet.

In der zweiten Kammer 14 ist weiterhin eine Filterschaltung 32 angeordnet, welche mit den Gleichstromseiten des ersten Inverters 3 und des zweiten Inverters 4, beispielsweise durch eine Verbindung der Filterschaltung 32 mit den Stromschienen 23 und/oder den Kontakten 21, 22 der Inverter 3, 4, verbunden ist. Durch die Filterschaltung 32 können insbesondere die durch die Schaltvorgänge in den Invertern 3, 4 entstehenden Störungen zumindest teilweise gefiltert werden, um eine störende Rückwirkung, insbesondere auf den Gleichstromzwischenkreis, zu vermeiden.

Weiterhin sind in der zweiten Kammer 14 ein gleichstromseitiger Anschluss 44 sowie ein Gleichstromsensor 36 angeordnet. Der gleichstromseitige Anschluss 44 sowie der Gleichstromsensor 36 sind mit den Gleichstromseiten der Inverter 3, 4 verbunden. Der Gleichstromsensor 36 kann vorteilhaft von beiden Invertern gemeinsam, insbesondere von den Steuereinrichtungen 25, 30, zum Betrieb der Inverter 3, 4 verwendet werden.

Das Gehäuse 5 weist im vorliegenden Ausführungsbeispiel einen mittleren, vier Gehäusewände umfassenden, umlaufenden Abschnitt 27 auf, welcher in Figur 2 an einer Vorderseite des Gehäuses 5 geschnitten dargestellt ist, um den Blick in das Innere des Gehäuses 5 zu ermöglichen. Die erste Kammer 13 wird teilweise durch den umlaufenden Abschnitt 27, den Plattenabschnitt 12 sowie einen ersten Gehäusedeckel 28 begrenzt. Entsprechend wird die zweite Kammer 14 des Gehäuses 5 durch den umlaufenden Abschnitt 27, den Plattenabschnitt 12 sowie einen zweiten Gehäusedeckel 29 begrenzt. Bei Einsatz der elektrischen Schaltungsanordnung 2 in einer elektrischen Antriebsanordnung, so wie sie beispielsweise in Figur 1 dargestellt ist, können an dem ersten Gehäusedeckel 28 und dem zweiten Gehäusedeckel 29 die erste elektrische Maschine 6 bzw. die zweite elektrische Maschine 7 jeweils tragend befestigt werden.

Das Gehäuse 5, insbesondere der umlaufende Abschnitt 27, der Plattenabschnitt 12 und die Gehäusedeckel 28, 29 können aus Metall gefertigt sein und insbesondere zumindest bereichsweise elektrisch leitfähig sein. Um die mechanische Stabilität zu erhöhen, können sie Versteifungsstrukturen wie Rippen, Sicken oder Ähnliches aufweisen.

Die Anordnung insbesondere der Leistungsmodule 17, 18 der Inverter 3, 4 an dem Plattenabschnitt 12 ermöglicht eine kompakte Anordnung der Inverter 3, 4 im Inneren des Gehäuses 5. Auf diese Weise kann eine kompakte Ausbildung der elektrischen Schaltungsanordnung 2 erreicht werden. Ferner ermöglicht der Plattenabschnitt 12, an dessen erster Seite 13 und zweiter Seite 14 die Komponenten der elektrischen Schaltungsanordnung 2 angeordnet sind, ein effizientes Kühlen dieser Komponenten.

Nicht dargestellt ist in Figur 2 ein Abschirmelement, welches zwischen dem zweiten Inverter 4 und der Filterschaltung 32 in der zweiten Kammer 14 angeordnet werden kann. Durch das Abschirmelement wird die zweite Kammer 24 in zwei Teilkammern aufgeteilt, wobei sich in der ersten Teilkammer der zweite Inverter 4 und in der zweiten Teilkammer die Filterschaltung 32 befindet. Auf diese Weise kann eine elektromagnetische Abschirmung der Filterschaltung 32 von dem zweiten Inverter 4 erreicht werden. Es ist insbesondere möglich, dass auch in der ersten Kammer 13 ein oder mehrere Abschirmelemente angeordnet werden und/oder dass in der zweiten Kammer 14 weitere Abschirmelemente angeordnet sind.

Der Plattenabschnitt 12 umfasst wenigstens einen, im Inneren verlaufenden Kühlkanal 33, welcher beispielsweise als eine Bohrung ausgeführt ist und an der geschnitten dargestellten Stirnfläche des Plattenabschnitts 12 in Fig. 2 zu erkennen ist. Auf diese Weise kann dem Plattenabschnitt 12 ein Kühlmedium zugeführt werden, mittels dem die an dem Plattenabschnitt 12 angeordneten Komponenten, also insbesondere die Leistungsmodule 17, 18 der Inverter 3, 4 sowie der Kondensator 19, der Gleichstromsensor 36 und/oder die Filterschaltung 32, gekühlt werden können. Am Äußeren des Gehäuses 5 können zwei mit dem Kühlkanal 33 korrespondierende Anschlüsse (nicht dargestellt) vorgesehen sein, über welchen ein Kühlmedium wie Kühlluft oder Kühlwasser den Kühlkanälen 33 im Inneren des Plattenabschnitts 12 zugeführt bzw. aus diesen abgeführt werden kann.

Um eine möglichst gute Kühlung der Leistungsmodule 17, 18 zu erreichen, weisen die Leistungsmodule 17, 18 jeweils an einer Seite einen Kühlkörper 34 auf. Die Leistungsmodule 17, 18 des ersten Inverters 3 und des zweiten Inverters 4 sind jeweils mit ihrem Kühlkörper 34 an dem Plattenabschnitt 12 angeordnet. Den Kühlkörpern 34 ist jeweils über den Kühlkanal 33 des Plattenabschnitts 12, vorliegend über die schlitzförmigen Öffnungen 35 in der ersten Seite 13 (in Figur 2 verdeckt) und der zweiten Seite 14, das Kühlmedium zuführbar. Die Kühlkörper 34 können z. B. als Mäander- oder Finnenstruktur ausgeführt sein, welche mit der ersten Seite 13 bzw. der zweiten Seite 14 des Plattenabschnitts 12 jeweils einen weiteren Kühlkanal begrenzen, wobei den weiteren Kühlkanälen jeweils durch zwei der Öffnungen 35 des Plattenabschnitts 12 ein Kühlmedium zuführbar ist. Die Kühlkörper 34 bzw. die Leistungsmodule 17, 18 können gegen den Plattenabschnitt 12 z. B. mit einer Axialdichtung abgedichtet sein, um ein unbeabsichtigtes Austreten des Kühlmediums in das Innere des Gehäuses 5 zu verhindern. Auf diese Weise wird eine effiziente Kühlung und eine mediendichte Ausbildung des Gehäuses 5 bzw. der elektrischen Schaltungsanordnung 2 ermöglicht.

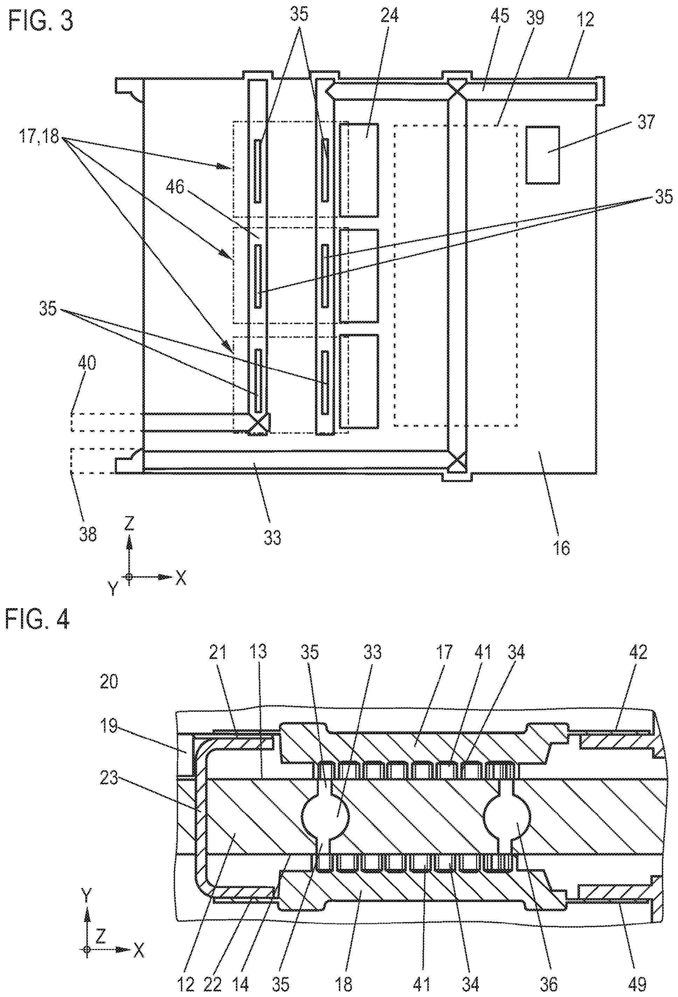

Figur 3 ist eine Detailansicht des Plattenabschnitts 12 dargestellt. Der Plattenabschnitt 12 ist dabei in Aufsicht auf die zweite Seite 14 des Plattenabschnitts 12 dargestellt, wobei die Öffnungen 24, 35 jeweils Durchgangsöffnungen darstellen, sodass sie auch auf der gegenüberliegenden, ersten Seite 13 des Plattenabschnitts 12 entsprechend vorhanden sind. Die Öffnungen 24 dienen zur Aufnahme der Stromschienen 23, welche die gleichstromseitigen Kontakte 21, 22 der Leistungsmodule 17, 18 miteinander verbinden. Durch eine weitere, ebenfalls als Durchgangsöffnung ausgebildete Öffnung 37 kann die Filterschaltung 32 mit dem Kondensator 19 bzw. dem ersten Inverter 3 verbunden werden.

Der im Inneren des Plattenabschnitts 12 verlaufende Kühlkanal 33 erstreckt sich beispielsweise von einem Zulauf 38 aus an einer Kante des Plattenabschnitts 12 entlang bis zu einem Knickpunkt. Von dem Knickpunkt aus erstreckt sich der Kühlkanal nach oben hin zu der gegenüberliegenden Kante des Plattenabschnitts 12 sowie zu einen dort verlaufenden, weiteren Abschnitt 45 des Kühlkanals 33.

Der gestrichelte dargestellte Bereich 39 dient auf der ersten Seite des Plattenabschnitts 13 zur Anordnung des Kondensators 19, sodass dieser über den Plattenabschnitt 12 bzw. den Kühlkanal 33 gekühlt werden kann. Die Kühlkörpern 34 der gestrichelt dargestellten Leistungsmodule 17, 18 werden über die schlitzförmigen Öffnungen 35 mit dem Kühlkanal 33 verbunden, wobei die Kühlstrukturen 34 jeweils mit der ersten Seite 13 bzw. der zweiten Seite 14 des Plattenabschnitts 12 wenigstens einen weiteren Kühlkanal begrenzen, dem über den Kühlkanal 33 ein Kühlmedium zuführbar ist. Das Kühlmedium wird dabei beispielsweise von den in Figur 3 dargestellten rechten schlitzförmigen Öffnungen 35 den Kühlstrukturen 34 zugeführt und über die linken Öffnungen 35 und einen weiteren Abschnitt 46 des Kühlkanals 33 einem Ablauf 40 des Kühlkanals 33 zugeführt.

Die Anordnung der Leistungsmodule 17, 18 an dem Plattenabschnitt 12 ist beispielhaft in der Schnittansicht in Figur 4 dargestellt. Ersichtlich begrenzen die an die erste Seite 13 und die zweite Seite 14 des Plattenabschnitts 12 anliegenden Kühlkörper 34, welche jeweils eine Mäander- oder eine Finnenstruktur aufweisen, mehrere weitere Kühlkanäle 41, welchen über die Öffnungen 35 aus dem Kühlkanal 13 ein Kühlmedium zuführbar ist. Eine Abfuhr des Kühlmediums erfolgt entsprechend über den Abschnitt 46 des Kühlkanals 33.

Dargestellt ist in Figur 4 weiterhin eine Verbindung zwischen den Kontakten 21 und 22 über eine Stromschiene 23. Die Stromschiene 23 kann z. B. als laminierte Stromschiene ausgeführt sein und mehrere gegeneinander isolierte Bleche umfassen. Über die gegeneinander isolierten Bleche kann abwechselt ein positives und ein negatives Potenzial, bzw. ein DC⁺ und ein DC⁻-Potential der Anschlüsse 21 und 22, miteinander verbunden werden. Auf diese Weise ergibt sich ein kompakter und störungsarmer Aufbau der Stromschienen 23. Weiterhin dargestellt ist ein Anschluss 20 des Kondensators 19 auf der Gleichstromseite der Leistungsmodule 17, 18. Die Leistungsmodule 17, 18 umfassen wechselstromseitige Kontakte 42 bzw. 43, welche aus dem Gehäuse 5 hinausgeführt werden und zum Anschluss der Inverter 3, 4 an die elektrischen Maschinen 6, 7 dienen können.

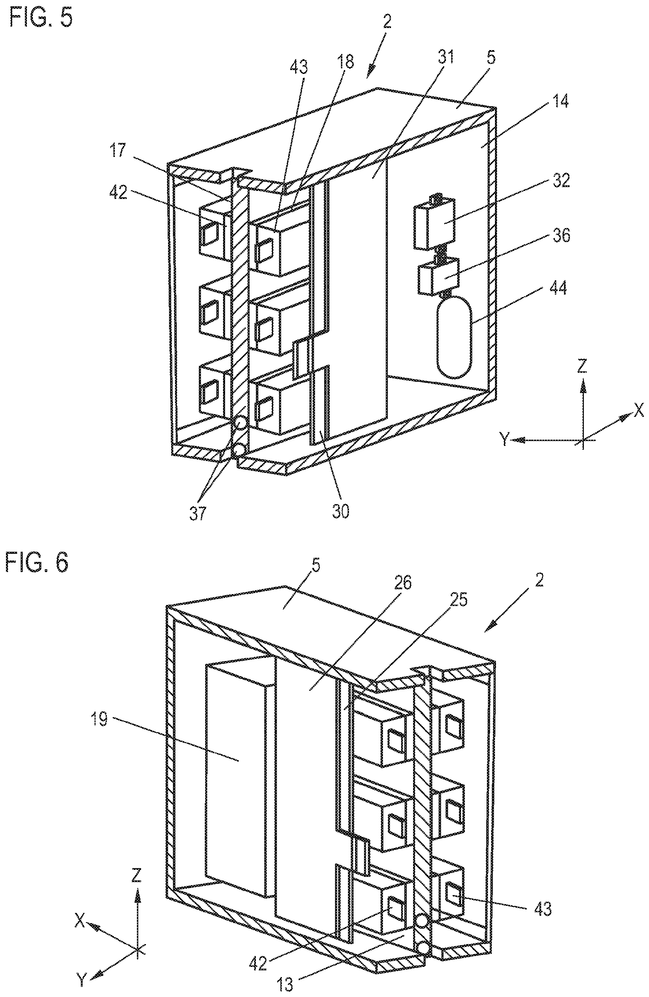

In Figur 5 ist die elektrische Schaltungsanordnung 2 in zusammengebautem Zustand dargestellt. Der Übersichtlichkeit halber ist das Gehäuse 5 an der Stirnseite geschnitten sowie ohne den zweiten Gehäusedeckel 29 dargestellt, sodass das Innere des Gehäuses 5 und die dort insbesondere in der zweiten Kammer 14 angeordneten Komponenten erkennbar sind. An der Stirnseite können die wechselstromseitigen Kontakte 42, 43 der Leistungsmodule 17, 18 jeweils mit einem oder mehreren wechselstromseitigen Anschlüssen (nicht dargestellt) verbunden werden, was beispielsweise eine elektrische Verbindung zwischen den Invertern 3, 4 und den elektrischen Maschinen 6, 7 einer elektrischen Antriebsanordnung 1 ermöglicht.

Auch auf der Gleichstromseite kann über den Anschluss 44 eine Verbindung der elektrischen Schaltungsanordnung, zum Beispiel zu einer Gleichstromquelle, vorgesehen sein. Der Anschluss 44 kann zum Beispiel mit dem Gleichstromsensor 36 und/oder mit der Filterschaltung 32 und über diese mit dem Kondensator 19 und den Gleichstromseiten der Inverter 3, 4 verbunden werden. Dies ermöglicht den Anschluss des Gehäuses 5 an eine Gleichstromquelle, z. B. eine Traktionsbatterie eines Kraftfahrzeugs mit elektrischem Antrieb. Das Gehäuse 5 kann weitere Anschlüsse umfassen, um beispielsweise die ersten und zweiten Steuerschaltungen 25, 26, 30, 31 mit weiteren Steuergeräten und/oder Datenkommunikationsleitungen oder ähnlichem verbinden zu können. Auch kann das Gehäuse 5 einen oder mehrere Zu- bzw. Abläufe zur Zufuhr bzw. Abfuhr von Kühlmedium an den Kühlkanal 33 aufweisen.

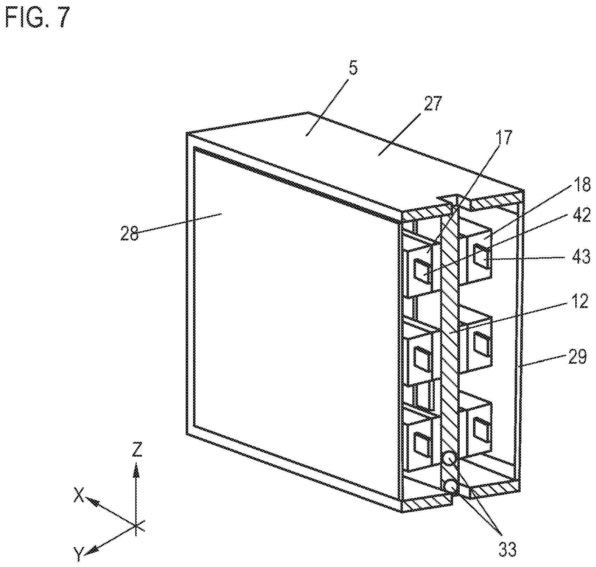

In Figur 6 ist eine weitere, teilweise geschnittene perspektivische Ansicht der elektrischen Schaltungsanordnung 2 dargestellt. Dabei ist Gehäuse 5 erneut an der Stirnseite geschnitten abgebildet. Weiterhin ist der erste Gehäusedeckel 28 nicht dargestellt, sodass insbesondere das Innere der ersten Kammer 13 und die dort angeordneten Komponenten erkennbar sind. In Figur 7 ist das Gehäuse 5 entsprechend mit aufgesetztem ersten Gehäusedeckel 28 dargestellt.

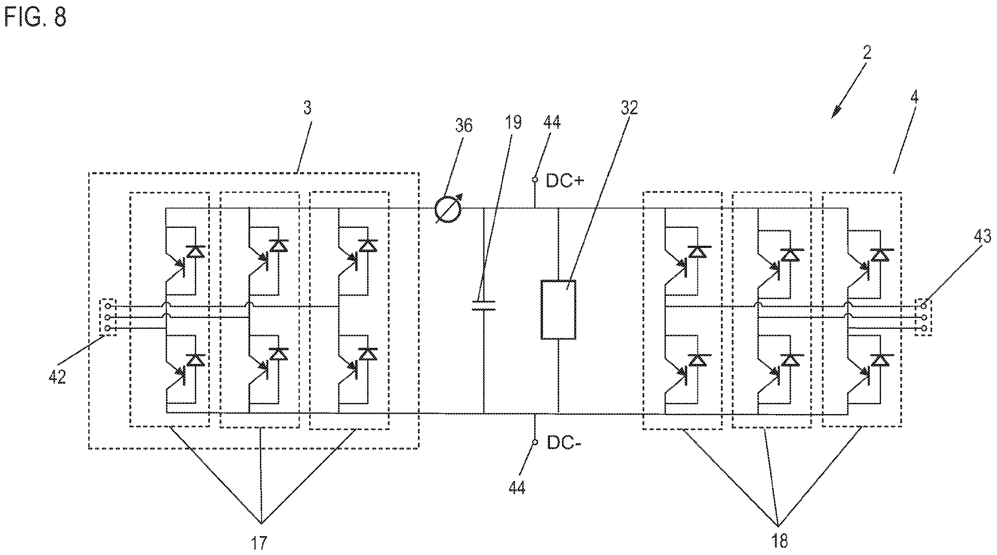

In Figur 8 ist ein schematischer Schaltplan der elektrischen Schaltungsanordnung 2 dargestellt. Der erste Inverter 3 und der zweite Inverter 4 sind jeweils als dreiphasige B6-Brückengleichrichter ausgeführt. Die Leistungsmodule 17 des ersten Inverters 3 sowie die Leistungsmodule 18 des zweiten Inverters 4 umfassen jeweils eine aus zwei Schaltelementen gebildete Halbbrücke. Die Schaltelemente sind dabei jeweils als ein Transistor ausgeführt.

Die Gleichstromseiten der Inverter 3, 4 sind mit dem Kondensator 19, dem Gleichstromsensor 36 und der Filterschaltung 32 verbunden. Der Kondensator 19 und die Filterschaltung 32 sind jeweils parallel zu den gleichstromseitigen Eingängen der Inverter 3, 4 angeordnet. Die wechselstromseitigen Kontakte 42 und 43 können, wie vorangehend beschrieben wurde, mit den elektrischen Maschinen 6, 7 verbunden werden, um diese beispielsweise über einen Gleichstrom zu betreiben. Die schematisch mit DC+ und DC- beschrifteten Kontakte sind mit dem Anschluss 44 verbunden und können beispielsweise mit einem elektrischen Energiespeicher, insbesondere einer Traktionsbatterie, verbunden werden.

Es ist möglich, dass die in der ersten Kammer 13 angeordneten Komponenten der elektrischen Schaltungsanordnung 2 zumindest teilweise in der zweiten Kammer 14 angeordnet werden und/oder dass die in der zweiten Kammer 14 angeordneten Komponenten zumindest teilweise in der ersten Kammer 13 angeordnet werden. Auch eine andere Aufteilung der Komponenten auf die erste Kammer 13 und die zweite Kammer 14 ist möglich. Insbesondere der Kondensator 19 und/oder die Filterschaltung 32 können auch jeweils zu einem Teil in der ersten Kammer 13 und in der zweiten Kammer 14 angeordnet werden.

### Bezugszeichenliste

- 1: Antriebsanordnung
- 2: Schaltungsanordnung
- 3: Inverter
- 4: Inverter
- 5: Gehäuse
- 6: Elektrische Maschine
- 7: Elektrische Maschine
- 8: Getriebeeinheit
- 9: Getriebeeinheit
- 10: Welle
- 11: Welle
- 12: Plattenabschnitt
- 13: Kammer
- 14: Kammer
- 15: Seite
- 16: Seite
- 17: Leistungsmodul
- 18: Leistungsmodul
- 19: Kondensator
- 20: Anschluss
- 21: Anschluss
- 22: Anschluss
- 23: Stromschienen
- 24: Öffnung
- 25: Steuereinheit
- 26: Steuereinheit
- 27: Abschnitt
- 28: Gehäusedeckel
- 29: Gehäusedeckel
- 30: Steuerschaltung
- 31: Steuerschaltung
- 32: Filterschaltung
- 33: Kühlkanal
- 34: Kühlkörper
- 35: Öffnung
- 36: Gleichstromsensor
- 37: Öffnung
- 38: Zulauf
- 39: Bereich
- 40: Ablauf
- 41: Kühlkanalabschnitt
- 42: wechselstromseitiger Kontakt
- 43: wechselstromseitiger Kontakt
- 44: Anschluss
- 45: Abschnitt
- 46: Abschnitt

## Patentansprüche

1. Elektrische Schaltungsanordnung, die aufweist:
einen ersten Inverter (3),
einen zweiten Inverter (4) und
ein Gehäuse (5) mit einem sich im Inneren des Gehäuses (5) erstreckenden Plattenabschnitt (12), wobei
der Plattenabschnitt (12) das Innere des Gehäuses (5) in eine erste Kammer (13) und eine zweite Kammer (14) teilt,
eine erste Seite (15) des Plattenabschnitts (12) die erste Kammer (13) zumindest teilweise begrenzt und eine der ersten Seite (15) gegenüberliegende zweite Seite (16) des Plattenabschnitts (12) die zweite Kammer (14) zumindest teilweise begrenzt, und
der erste Inverter (3) und der zweite Inverter (4) jeweils wenigstens ein Leistungsmodul (17, 18) umfassen und das Leistungsmodul (17) des ersten Inverters (3) an der ersten Seite (15) des Plattenabschnitts (12) angeordnet ist und das Leistungsmodul (18) des zweiten Inverters (4) an der zweiten Seite (16) des Plattenabschnitts (12) angeordnet ist,
**dadurch gekennzeichnet, dass**
Gleichstromseiten des ersten Inverters (3) und des zweiten Inverters (4) mit einer in der zweiten Kammer (14) angeordneten Filterschaltung (32) verbunden sind.

2. Elektrische Schaltungsanordnung nach Anspruch 1, **dadurch gekennzeichnet, dass** der Plattenabschnitt (12) wenigstens einen sich im Inneren des Plattenabschnitts (12) erstreckenden Kühlkanal (33) aufweist.

3. Elektrische Schaltungsanordnung nach Anspruch 2, **dadurch gekennzeichnet, dass**
die Leistungsmodule (17, 18) jeweils einen Kühlkörper (34) aufweisen,
die Leistungsmodule (17, 18) jeweils mit dem Kühlkörper (34) an dem Plattenabschnitt (12) angeordnet sind, und
den Kühlkörpern (34) über den Kühlkanal (33) des Plattenabschnitts (12) ein Kühlmedium zuführbar ist.

4. Elektrische Schaltungsanordnung nach einem der Ansprüche 1 bis 3, **dadurch gekennzeichnet, dass** die Gleichstromseiten des ersten Inverters (3) und des zweiten Inverters (4) mit einem in der ersten Kammer (13) und insbesondere an der ersten Seite (15) des Plattenabschnitts (12) angeordneten Kondensator (19) verbunden sind.

5. Elektrische Schaltungsanordnung nach Anspruch 4, **dadurch gekennzeichnet, dass** der Kondensator (19) mit einer Gleichstromseite des Leistungsmoduls (18) des zweiten Inverters (4) über wenigstens eine Stromschiene (23) verbunden ist, die sich durch eine Aussparung (24) in dem Plattenabschnitt (12) erstreckt.

6. Elektrische Schaltungsanordnung nach Anspruch 5, **dadurch gekennzeichnet, dass** die Stromschiene (23) als eine mehrere leitfähige Bleche umfassende laminierte Stromschiene ausgeführt ist.

7. Elektrische Schaltungsanordnung nach einem der Ansprüche 1 bis 6, **dadurch gekennzeichnet, dass** zwischen der Filterschaltung (32) und dem Leistungsmodul (18) des zweiten Inverters (4) ein Abschirmelement angeordnet ist.

8. Elektrische Schaltungsanordnung nach einem der Ansprüche 1 bis 7, **dadurch gekennzeichnet, dass**
in der ersten Kammer (13) wenigstens eine erste Steuereinrichtung (25, 26) und in der zweiten Kammer (14) wenigstens eine zweite Steuereinrichtung (30, 31) angeordnet ist,
die erste Steuereinrichtung (25, 26) zum Steuern des ersten Inverters (3) und/oder einer mit dem ersten Inverter (3) verbundenen Komponente ausgebildet ist und
die zweite Steuereinrichtung (30, 31) zum Steuern des zweiten Inverters (4) und/oder einer mit dem zweiten Inverter (4) verbundenen Komponente ausgebildet ist.

9. Elektrische Antriebsanordnung, die eine elektrische Schaltungsanordnung (2) nach einem der Ansprüche 1 bis 8, eine erste elektrische Maschine (6) und eine zweite elektrische Maschine (7) aufweist, wobei die erste elektrische Maschine (6) und die zweite elektrische Maschine (7) an dem Gehäuse (5) der elektrischen Schaltungsanordnung (2) tragend befestigt sind.

## Claims

1. An electrical circuit arrangement having:
a first inverter (3),
a second inverter (4) and
a housing (5) with a plate section (12) extending in the interior of the housing (5), wherein
the plate section (12) divides the interior of the housing (5) into a first chamber (13) and a second chamber (14),
a first side (15) of the plate section (12) at least partially delimits the first chamber (13) and a second side (16) of the plate section (12), situated opposite the first side (15), at least partially delimits the second chamber (14), and
the first inverter (3) and the second inverter (4) each comprise at least one power module (17, 18), and the power module (17) of the first inverter (3) is arranged on the first side (15) of the plate section (12) and the power module (18) of the second inverter (4) is arranged on the second side (16) of the plate section (12),
**characterised in that**
direct current sides of the first inverter (3) and the second inverter (4) are connected to a filter circuit (32) arranged in the second chamber (14).

2. The electrical circuit arrangement according to claim 1, **characterised in that** the plate section (12) has at least one cooling channel (33) extending in the interior of the plate section (12).

3. The electric circuit arrangement according to claim 2, **characterised in that**
the power modules (17, 18) each have a heat sink (34),
the power modules (17, 18) are each arranged with the heat sink (34) on the plate section (12), and
a cooling medium can be supplied to the heat sinks (34) via the cooling channel (33) of the plate section (12).

4. The electrical circuit arrangement according to any one of claims 1 to 3, **characterised in that** the direct current sides of the first inverter (3) and the second inverter (4) are connected to a capacitor (19) arranged in the first chamber (13) and in particular on the first side (15) of the plate section (12).

5. The electrical circuit arrangement according to claim 4, **characterised in that** the capacitor (19) is connected to a direct current side of the power module (18) of the second inverter (4) via at least one busbar (23) that extends through an opening (24) in the plate section (12).

6. The electrical circuit arrangement according to claim 5, **characterised in that** the busbar (23) is designed as a laminated busbar comprising several conductive sheets.

7. The electrical circuit arrangement according to any one of claims 1 to 6, **characterised in that** a shielding element is arranged between the filter circuit (32) and the power module (18) of the second inverter (4).

8. The electrical circuit arrangement according to any one of claims 1 to 7, **characterised in that**
at least one first control device (25, 26) is arranged in the first chamber (13) and at least one second control device (30, 31) is arranged in the second chamber (14),
the first control device (25, 26) is designed to control the first inverter (3) and/or a component connected to the first inverter (3), and
the second control device (30, 31) is designed to control the second inverter (4) and/or a component connected to the second inverter (4).

9. An electrical drive arrangement having an electrical circuit arrangement (2) according to any one of claims 1 to 8, a first electrical machine (6) and a second electrical machine (7), wherein the first electrical machine (6) and the second electrical machine (7) are attached in a load-bearing manner to the housing (5) of the electrical circuit arrangement (2).

## Revendications

1. Agencement de circuit électrique, qui présente :
un premier onduleur (3),
un second onduleur (4) et
un boîtier (5) comportant une section de plaque (12) s'étendant à l'intérieur du boîtier (5), dans lequel
la section de plaque (12) divise l'intérieur du boîtier (5) en une première chambre (13) et une seconde chambre (14),
un premier côté (15) de la section de plaque (12) délimite au moins à certains endroits la première chambre (13) et un second côté (16) de la section de plaque (12) opposé au premier côté (15) délimite au moins à certains endroits la seconde chambre (14), et
le premier onduleur (3) et le second onduleur (4) comprennent respectivement au moins un module de puissance (17, 18) et le module de puissance (17) du premier onduleur (3) est agencé sur le premier côté (15) de la section de plaque (12) et le module de puissance (18) du second onduleur (4) est agencé sur le second côté (16) de la section de plaque (12),
**caractérisé en ce que**
des côtés de courant continu du premier onduleur (3) et du second onduleur (4) sont connectés à un circuit de filtrage (32) agencé dans la seconde chambre (14).

2. Agencement de circuit électrique selon la revendication 1, **caractérisé en ce que** la section de plaque (12) présente au moins un canal de refroidissement (33) s'étendant à l'intérieur de la section de plaque (12).

3. Agencement de circuit électrique selon la revendication 2, **caractérisé en ce que**
les modules de puissance (17, 18) présentent respectivement un corps de refroidissement (34),
les modules de puissance (17, 18) sont respectivement agencés avec le dissipateur thermique (34) sur la section de plaque (12), et
un milieu de refroidissement peut être acheminé aux corps de refroidissement (34) par l'intermédiaire du canal de refroidissement (33) de la section de plaque (12).

4. Agencement de circuit électrique selon l'une des revendications 1 à 3, **caractérisé en ce que** les côtés de courant continu du premier onduleur (3) et du second onduleur (4) sont connectés à un condensateur (19) agencé dans la première chambre (13) et en particulier sur le premier côté (15) de la section de plaque (12).

5. Agencement de circuit électrique selon la revendication 4, **caractérisé en ce que** le condensateur (19) est connecté à un côté de courant continu du module de puissance (18) du second onduleur (4) par l'intermédiaire d'au moins un rail conducteur (23) qui s'étend à travers un évidement (24) dans la section de plaque (12).

6. Agencement de circuit électrique selon la revendication 5, **caractérisé en ce que** le rail conducteur (23) est conçu comme un rail conducteur laminé comprenant plusieurs feuilles conductrices.

7. Agencement de circuit électrique selon l'une des revendications 1 à 6, **caractérisé en ce que**, entre le circuit de filtrage (32) et le module de puissance (18) est agencé un élément de blindage (4).

8. Agencement de circuit électrique selon l'une des revendications 1 à 7, **caractérisé en ce que**
dans la première chambre (13) est agencé au moins un premier dispositif de commande (25, 26) et dans la seconde chambre (14) est agencé au moins un second dispositif de commande (30, 31),
le premier dispositif de commande (25, 26) est conçu pour commander le premier onduleur (3) et/ou un composant connecté au premier onduleur (3) et
le second dispositif de commande (30, 31) est conçu pour commander le second onduleur (4) et/ou un composant connecté au second onduleur (4).

9. Agencement d'entraînement électrique, qui présente un agencement de circuit électrique (2) selon l'une des revendications 1 à 8, une première machine électrique (6) et une seconde machine électrique (7), dans lequel la première machine électrique (6) et la seconde machine électrique (7) sont fixées de manière portante au boîtier (5) de l'agencement de circuit électrique (2).
